Europäisches Patentamt

European Patent Office

Office européen des brevets

(19)

(11) Publication number: **0 201 696 B1**

# EUROPEAN PATENT SPECIFICATION

(12)

(45) Date of publication of patent specification: **13.03.91**  (51) Int. Cl.5: **C23C 16/26**, //C30B29/02

(21) Application number: **86103833.9**

(22) Date of filing: **20.03.86**

Divisional application 88113145 filed on 12.08.88.

(54) Production of carbon films.

(30) Priority: 20.03.85 JP 56478/85
22.03.85 JP 59275/85
26.03.85 JP 64572/85

(43) Date of publication of application:
20.11.86 Bulletin 86/47

(45) Publication of the grant of the patent:
13.03.91 Bulletin 91/11

(84) Designated Contracting States:
DE FR GB

(56) References cited:
GB-A- 1 032 102
GB-A- 1 045 591
GB-A- 1 095 294
US-A- 3 317 338

Journal of Applied Physics, vol. 37, no. 5,
April 1964, pages 2179-2181

Chemical Abstracts, vol. 76, no. 10, March 6,
1972, page 348, ref. no. 50961d; Columbus
Ohio, US - A.E.B. Presland et al.: Nucleation
and growth of pyrolytic graphite films on
nickel substrates"

(73) Proprietor: SHARP KABUSHIKI KAISHA
22-22 Nagaike-cho Abeno-ku
Osaka 545(JP)

(72) Inventor: Yoshimoto, Yoshikasu
Yabuuchi Heights 202 298, Tainosho-cho
Tenri-shi Nara-ken(JP)
Inventor: Suzuki, Tomonari
96-31, Nishi Ikejiri-cho
Kashihara-shi Nara-ken(JP)
Inventor: Higashigaki, Yoshiyuki
2-14-5, Fuse Shinmachi
Kashiwa-shi Chiba-ken(JP)
Inventor: Nakajima, Shigeo
2-7-1, Omiya-cho
Nara-shi Nara-ken(JP)
Inventor: Inoguchi, Toshio
200-24, Naka-cho
Kashihara-shi Nara-ken(JP)

(74) Representative: von Kreisler, Alek,
Dipl.-Chem. et al
Deichmannhaus am Hauptbahnhof
W-5000 Köln 1(DE)

Patents Abstracts of Japan, vol. 9, no. 108, (C-280) (1831), May 11, 1985

Journal of Applied Physics, vol. 39, no. 6, May 1968, pages 2915-2922; J.C. Angus et al.: "Growth of diamond seed crystals by vapor deposition"

## Description

The present invention relates to a process for preparing a pyrolitic carbon film.

The graphite has such unique properties associated with its layer structure as anisotropies in thermal and electrical conductivity. However, the synthesis of graphite is required extreme conditions of pressure and temperature due to the fact that it has inaccessible melting point and the extremely low sublimation pressure. For example, so called HOPG is prepared by decomposing a gaseous hydrocarbon (e.g. methane) at 2,000°C and then hot pressing the resulting pyrolytic material at still higher temperature. It is now well known that most carboneceous materials are well graphitized when they are subjected to a heat treatment at higher temperature above 2,500°C. On the other hand, there have been many efforts to prepare pyrolytic carbons, at the low decomposition temperature utilizing dehydrogenation, dehydrohalogenation, decarbonic acid, dehydration of selected hydrocarbons. However, carbon deposits thus obtained are of so poorly ordered state that they are insufficient to provide anisotropic materials or device. There also has been known carbon fiber which is obtained by heat treatment of fibrous polymer compound at high temperature. These carbon fibers are widely used for structural materials, but their unstableness in physical properties debases the usefulness for new electronic materials or device utilizing anisotropic electrical and thermal conductivity due to lack of reproducibility.

JP-A-59 232 904 describes a method for preparing a pyrolytic carbon film, wherein diethynylbenzene, together with a carrier gas, is introduced into a reaction chamber, is thermally decomposed at a temperature of preferably about 600 to 1000°C and the carbon film is deposited onto different substrates, e.g. a quartz substrate.

The present invention is to provides a method for preparing pyrolytic carbon films with highly ordered graphite structure at relatively low temperature. The method comprises thermal decomposition of benzene introduced by a carrier gas into a reaction chamber to deposit the carbon films onto a single-crystalline substrate.

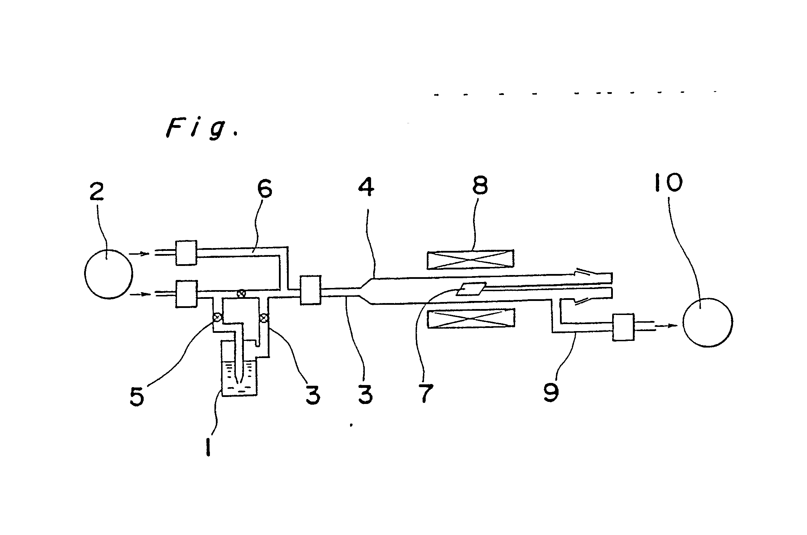

The Figure shows a schematical view of the apparatus for preparing the pyrolytic carbon film of the present invention.

Benzene employed in the present invention as a starting material is generally decomposed approximately at 1,000°C. A method for supplying benzene includes bubbling method, vaporization method, sublimation method and the like.

The carrier gas used to introduce benzene into the reaction chamber is hydrogen or an inert gas, such as argon, nitrogen. When the bubbling method for supplytig benzene is employed, hydrogen or argon is preferable for the carrier gas.

The establishment of low temperature growth of pyrolytic carbon films provides practical utilization of its anisotropic properties to new electronic material.

The single-crystalline substrate includes silicon, sapphire, silicon carbide (including alpha-type and beta-type), boron nitride, kish graphite, high orientation graphite and the like, which is required to have no modification at about 1,000°C.

The following example illustrates the present invention, but it is not construed as limiting the present invention.

## Example

In the Fig., benzene is selected as a starting material and the bubbling method using argon as carrier gas is employed for the preparation of pyrolytic carbon films. The low pressure CVD can also be achieved with the apparatus shown in the Fig. This method can provide carbon films in uniform thickness compared with bubbling method under atmospheric pressure.

Benzene moleculars are introduces by bubbling method of the carrier gas into a quartz reaction tube 4 through a pyrex glass tube 3 from a feed stock 1 wherein benzene purified through vacuum distillation is accommodated. Supply rate of benzene is determined by valve 5 which regulates the flow rate of Ar bubbling gas in which benzene vapor is saturated. In order to supply benzene strictly at constant rate of several mmol/hour, the feed stock is kept at constant temperature. The benzene partial concentration is controlled by another Ar gas flow through pyrex tube 6. A piece of single-crystalline substrate, placed at the center position on the pedestol 7, is heated up to 1,000°C by the heating furnace 8 around the reaction tube 4. Thus benzene molecules led into the reaction tube 4 are thermally decomposed at 1,000°C and the carbon deposit having luster are formed on the single-crystalline substrate. The remaining vapor led to the reaction tube 4 is discharged outside 10 through a discharge pipe 9.

The density of carbon deposits obtained were determined to be 2.1±0.1g/cm² by the float method using a mixture of carbon tetrachloride and methane dibromide. Infrared spectrum of the carbon films did not show the existence of -CH, -CH₂ and -CH₃.

## Claims

1. Process for preparing pyrolytic carbon film having a highly ordered graphite structure which comprises

introducing benzene together with a carrier gas into a reaction chamber,

thermally decomposing said benzene at a temperature up to 1000 ° C, and

depositing the carbon film onto a single-crystalline substrate.

## Revendications

1. Procédé de préparation de film de carbone pyrolytique possédant une structure graphitique très ordonnée, comprenant

l'introduction de benzène ainsi que d'un gaz vecteur dans une chambre à réaction

la décomposition thermique dudit benzène à une température atteignant 1 000 ° C, et

le dépôt du film de carbone sur un substrat monocristallin.

## Ansprüche

1. Verfahren zur Herstellung eines pyrolytischen Kohlenstoff-Films mit hochgradig geordneter Graphit-Struktur, umfassend

das Einleiten von Benzol zusammen mit einem Träger-Gas in eine Reaktionskammer, das thermische Zersetzen des Benzols bei einer Temperatur bis zu 1000 ° C und das Abscheiden des Kohlenstoff-Films auf einem Einkristall-Substrat.

*Fig.*